# EUROPÄISCHE PATENTANMELDUNG

(11) **EP 1 071 142 A2**
(43) Veröffentlichungstag der Anmeldung: **24.01.2001**
(21) Anmeldenummer: 00890226.4
(22) Anmeldetag: 20.07.2000
(51) Int. Cl.: H01L 33/00, G08G 1/095, F21K 7/00, F21W 111/00

(54) **Verfahren zur Bestückung von Leiterplatten mit Leuchtdioden**

(30) Priorität: 23.07.1999 AT 128099
(71) Anmelder: Chip & Byte Datentechnik GmbH, 5020 Salzburg (AT)
(72) Erfinder: Schwarz, Peter, 5141 Moosdorf (AT); Fischer, Markus, 5282 Ranshofen (AT)
(74) Vertreter: Babeluk, Michael, Dipl.-Ing. Mag.

(57) **Zusammenfassung**

Die vorliegende Erfindung betrifft ein Verfahren zur Bestückung von Leiterplatten (10) mit Leuchtdioden (3) insbesondere zur Herstellung von Leuchtmitteln, bei dem die Leuchtdioden (3) mit einem ersten Klebstoff (4) mit der Leiterplatte (10) verbunden werden und bei dem die Kontakte der Leuchtdioden (3) mit entsprechenden Kontakten auf der Leiterplatte (10) verbunden werden. Die Erfindung ist dadurch gekennzeichnet, dass die Leiterplatte (10) vor der Bestückung gebogen wird und dass die Verbindung der Kontakte der Leuchtdioden (3) mit den Kontakten der Leiterplatte (10) mit einem weiteren Klebstoff (6) erfolgt.

## Beschreibung

Die Erfindung betrifft ein Verfahren gemäß dem Oberbegriff von Patentanspruch 1.

Bei modernen Verkehrsampeln besteht das Leuchtmittel im allgemeinen nicht mehr aus einer Glühlampe sondern aus einer Leiterplatte, die mit einer Vielzahl von Leuchtdioden bestückt ist. Eine solche Lösung bietet nicht nur den Vorteil einer erhöhten Ausfallsicherheit, sondern ermöglicht auch die Erzielung von günstigen optischen Eigenschaften. Es wird nämlich von Verkehrsampeln verlangt, dass einfallendes Fremdlicht, wie etwa Sonnenlicht, weitgehend absorbiert wird, um auch bei ungünstigen Lichtverhältnissen eine klare Erkennbarkeit des Zustandes der Verkehrsampel zu ermöglichen. Es sind Verkehrsampeln bekannt, bei denen eine ebene Leiterplatte, die mit Leuchtdioden bestückt ist, als Leuchtmittel verwendet wird, wobei ein Linsenelement vorgeschaltet ist, das die Leiterplatte nicht nur abdeckt, sondern auch die gewünschten optischen Eigenschaften bewirkt. Ein solches Linsenelement ist jedoch aufwendig in der Herstellung und die Möglichkeit Streulicht zu unterdrücken ist begrenzt.

Aus der US 5,896,093 A ist eine Leuchtanordnung für Ampeln bekannt, bei der Leuchtdioden eingesetzt werden, die auf einer ebenen Leiterplatte angeordnet sind. Eine ähnliche Lösung ist in der US 5,785,418 A gezeigt.

Aufgabe der vorliegenden Erfindung ist es, diese Nachteile zu vermeiden und ein Verfahren der oben beschriebenen Art so weiterzubilden, dass eine möglichst einfache und kostengünstige Fertigung möglich ist.

Erfindungsgemäß ist vorgesehen, dass die Leiterplatte vor der Bestückung gebogen wird und dass die Verbindung der Kontakte der Leuchtdioden mit den Kontakten der Leiterplatte mit einem weiteren Klebstoff erfolgt.

Durch die Verwendung einer gebogenen Leiterplatte kann die Optik von Verkehrsampeln wesentlich einfacher und kostengünstiger gestaltet werden, und es kann das Streulicht besser unterdrückt werden. Die Herstellung einer gebogenen Leiterplatte durch Auflöten der einzelnen Leuchtdioden ist jedoch aufgrund der komplizierten Geometrie sehr aufwendig, da die Positionierung des Heizelements für jeden Kontakt exakt erfolgen muss.

Die Erfindung ist jedoch auch zur Herstellung anderer Leuchtmittel geeignet, bei denen eine bestimmte Abstrahlcharakteristik wesentlich ist. So können etwa herkömmliche Halogenleuchten durch solche Leuchtmittel in vorteilhafter Weise ersetzt werden.

Vorzugsweise ist vorgesehen, dass der weitere Klebstoff unterschiedlich vom ersten Klebstoff ist. Der erste Klebstoff soll eine möglichst gute Wärmeübertragung gewährleisten, um eine ausreichende Kühlung der Leuchtdioden sicherzustellen, während der weitere Klebstoff einen guten elektrischen Kontakt sicherstellen soll.

Eine besonders vorteilhafte Lösung ist in diesem Zusammenhang dann gegeben, wenn die Leiterplatte durch Aufkleben einer die Leiterbahnen aufweisenden Folie auf ein Substrat hergestellt wird. Das Substrat kann etwa durch eine Metallplatte gebildet werden. Auf diese Weise kann die Wärme der Leuchtdioden besonders wirksam abgeführt werden.

In einer besonders bevorzugten Ausführungsvariante des erfindungsgemäßen Verfahrens ist vorgesehen, dass die bestückte Leiterplatte zum Aushärten der Klebstoffe auf eine Temperatur zwischen 80°C und 110°C erwärmt wird. Auf diese Weise können Klebstoffe gut ausgehärtet werden, ohne die für die Leuchtdioden zulässige Temperatur zu überschreiten.

Weiters betrifft die vorliegende Erfindung eine Leiterplatte, die mit einer Mehrzahl von Leuchtdioden bestückt ist, insbesondere zur Verwendung als Leuchtmittel von Verkehrsampeln oder von anderen Leuchten, wobei die Leuchtdioden mit einem ersten Klebstoff mit der Leiterplatte verbunden sind. Erfindungsgemäß ist dabei vorgesehen, dass die Leiterplatte gekrümmt ausgebildet ist und dass die Verbindung der Kontakte der Leuchtdioden mit den Kontakten der Leiterplatte mit einem weiteren Klebstoff ausgeführt ist.

Besonders günstig ist es dabei, wenn die Krümmung zylindrisch ist. Eine solche Krümmung, die nicht notwendigerweise kreiszylindrisch sein muss, ermöglicht eine einfache Herstellung bei günstigen optischen Eigenschaften.

Eine bevorzugte Ausführungsvariante der Erfindung sieht vor, dass die Leuchtdioden parallel zur Tangente an die Leiterplatte ausgerichtet sind. Bei ebenen Leiterplatten ist eine parallele Ausrichtung der Leuchtdioden üblich. Es hat sich jedoch herausgestellt, dass bei gekrümmten Leiterplatten eine Ausrichtung in der Tangentialebene zu vorteilhaften optischen Eigenschaften führt.

In der Folge wird die vorliegende Erfindung anhand der in den Figuren dargestellten Ausführungsbeispielen näher erläutert. Es zeigen:
- Fig. 1 einen schematischen Schnitt durch eine erfindungsgemäße Leiterplatte;
- Fig. 2 eine axonometrische Ansicht einer Leuchtdiode;
- Fig. 3 eine Ansicht der Leuchtdiode von Fig. 2 von oben; und
- Fig. 4 eine Ansicht der Leuchtdiode von Fig. 2 von unten.

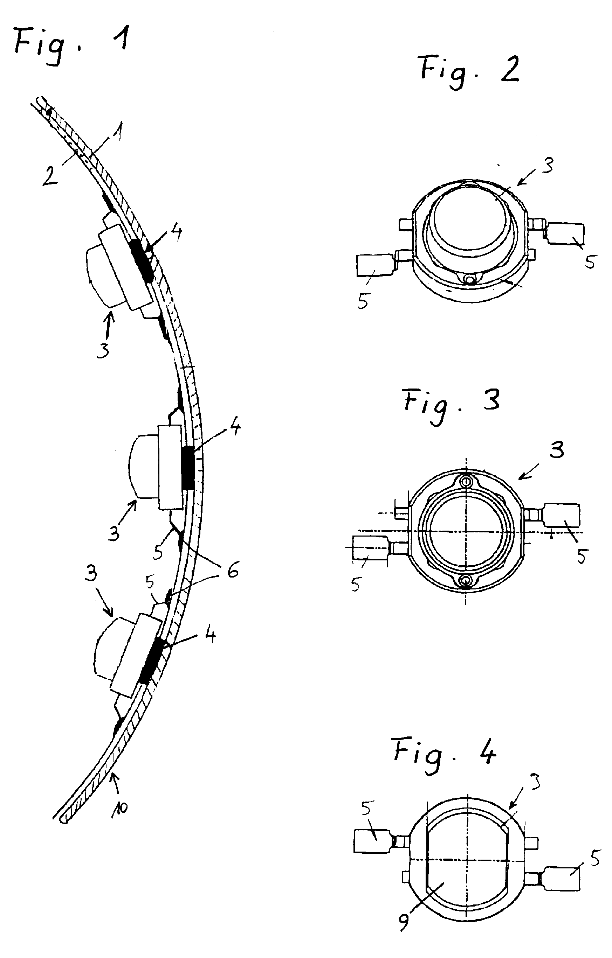

Die Leiterplatte 10 von Fig. 1 besteht aus einer kreiszylindrisch gebogenen starren Trägerplatte 1 aus einer Aluminiumlegierung, auf die eine Folie 2, die als Flexprint bezeichnet wird, aufgeklebt ist. Zur Verklebung wird ein bis mindestens 140°C hitzebeständiger Klebstoff verwendet. Die Folie 2 besitzt in den Figuren nicht dargestellte Leiterbahnen zur elektrischen Versorgung der darauf befestigten Bauelemente, wie etwa der Leuchtdioden 3. Diese Leuchtdioden 3 sind mit einem ersten Klebstoff 4 mit hoher Wärmeleitfähigkeit an der Folie 2 bzw. der Trägerplatte 1 angeklebt. Bei dem Klebstoff 4 handelt es sich um einen Einkomponentenkleber auf Epoxyharzbasis, der unter der Bezeichnung "AMICON 3503" im Handel erhältlich ist. Dieser Klebstoff besitzt eine Wärmeleitfähigkeit von etwa 1 W/mK. Bei einer Temperatur von 100°C beträgt die erforderliche Zeit für die Aushärtung 30 Minuten.

Die Leuchtdioden 3 besitzen seitlich vorstehende Kontakte 5, die mit einem elektrisch leitfähigen Klebstoff 6 mit der Folie 2 verbunden werden. Bei dem Klebstoff 6 handelt es sich um einen Einkomponentenkleber auf Epoxyharzbasis mit einem Silberanteil von etwa 75 Gew.% Silber, der unter der Bezeichnung "AMICON CE 3502" im Handel erhältlich ist. Bei einer Temperatur von 100°C beträgt die erforderliche Zeit für die Aushärtung 45 Minuten.

In den Fig. 2 bis 4 sind die Leuchtdioden 3 detailliert dargestellt. Die Leuchtdioden 3 bestehen aus einem Grundkörper 7, auf dem eine Linse 8 befestigt ist, in der das eigentliche Leuchtmittel angeordnet ist. Die Kontakte 5 stehen seitlich vom Grundkörper 7 vor. An der Rückseite des Grundkörpers 7 ist eine Kühlfläche 9 vorgesehen, die zur Wärmeabfuhr über den Klebstoff 6 dient.

In der Folge wird der Ablauf des erfindungsgemäßen Verfahrens erklärt werden. Zunächst wird die Folie 2 auf die gekrümmte Trägerplatte 1 aufgeklebt. Danach wird die so hergestellte Leiterplatte 10 in eine Aufnahmeeinrichtung zum Transport in der Bestückungslinie eingespannt, und es wird die Aufnahmeeinrichtung in die Bestückungslinie eingelegt. Danach wird an vorbestimmten Punkten der Leiterplatte 10 der erste Klebstoff 4 aufgebracht. In der Folge wird der weitere Klebstoff 6 auf die entsprechenden Kontakte der Leiterplatte 10 dispensiert. Danach wird in einem Bestückungsautomaten, der mit einem Sensorstopp ausgestattet ist, eine Leuchtdiode nach der anderen gesetzt. Der Sensorstopp ist insofern wichtig, als die genaue Position der Leiterplatte 10 in der Bewegungsrichtung des Bestückungswerkzeugs nicht genau bekannt ist. Durch die Kraftbegrenzung werden so Beschädigungen an den Bauteilen vermieden, und es wird eine sichere Kontaktierung erreicht. Nach dem Bestücken werden die Klebstoffe 4 und 6 in einem Ofen in 45 Minuten bei 100°C ausgehärtet.

Die vorliegende Erfindung ermöglicht es, Leuchtmittel in einfacher und kostengünstiger Weise herzustellen, die genau definierte optische Eigenschaften aufweisen. Solche Leuchtmittel sind für Verkehrsampeln, aber auch für andere Einsatzzwecke, wie etwa Fahrzeugleuchten, Signallampen oder für effektvolle Raumbeleuchtung geeignet.

## Patentansprüche

1. Verfahren zur Bestückung von Leiterplatten (10) mit Leuchtdioden (3) insbesondere zur Herstellung von Leuchtmitteln von Verkehrsampeln, bei dem die Leuchtdioden (3) mit einem ersten Klebstoff (4) mit der Leiterplatte (10) verbunden werden und bei dem die Kontakte der Leuchtdioden (3) mit entsprechenden Kontakten auf der Leiterplatte (10) verbunden werden, dadurch gekennzeichnet, dass die Leiterplatte (10) vor der Bestückung gebogen wird und dass die Verbindung der Kontakte der Leuchtdioden (3) mit den Kontakten der Leiterplatte (10) mit einem weiteren Klebstoff (6) erfolgt.

2. Verfahren nach Anspruch 1, dadurch gekennzeichnet, dass der weitere Klebstoff (6) unterschiedlich vom ersten Klebstoff (4) ist.

3. Verfahren nach einem der Ansprüche 1 oder 2, dadurch gekennzeichnet, dass das Aufbringen des ersten Klebstoffs (4) vor dem Aufbringen des weiteren Klebstoffs (6) erfolgt.

4. Verfahren nach einem der Ansprüche 1 bis 3, dadurch gekennzeichnet, dass die Leiterplatte (10) durch Aufkleben einer die Leiterbahnen aufweisenden Folie (2) auf ein Substrat (1) hergestellt wird.

5. Verfahren nach einem der Ansprüche 1 bis 4, dadurch gekennzeichnet, dass die bestückte Leiterplatte (10) zum Aushärten der Klebstoffe auf eine Temperatur zwischen 80°C und 110°C erwärmt wird.

6. Leiterplatte, die mit einer Mehrzahl von Leuchtdioden (3) bestückt ist, insbesondere zur Verwendung als Leuchtmittel von Verkehrsampeln, wobei die Leuchtdioden (3) mit einem ersten Klebstoff mit der Leiterplatte (10) verbunden sind, dadurch gekennzeichnet, dass die Leiterplatte (10) gekrümmt ausgebildet ist und dass die Verbindung der Kontakte der Leuchtdioden (3) mit den Kontakten der Leiterplatte (10) mit einem weiteren Klebstoff (6) ausgeführt ist.

7. Leiterplatte nach Anspruch 6, dadurch gekennzeichnet, dass der weitere Klebstoff (6) unterschiedlich vom ersten Klebstoff (4) ist.

8. Leiterplatte nach einem der Ansprüche 6 oder 7, dadurch gekennzeichnet, dass eine die Leiterbahnen aufweisende Folie (2) auf ein Substrat (1) aufgebracht ist

9. Leiterplatte nach einem der Ansprüche 6 bis 8, dadurch gekennzeichnet, dass die Krümmung zylindrisch ist.

10. Leiterplatte nach einem der Ansprüche 6 bis 9, dadurch gekennzeichnet, dass die Leuchtdioden (3) parallel zur örtlichen Tangentialebene der Leiterplatte (10) ausgerichtet sind.

11. Leuchtmittel mit mindestens einer Leiterplatte (10) nach einem der Ansprüche 6 bis 10 und einem Linsenelement, das vor der Leiterplatte (10) angeordnet ist.

12. Verkehrsampel mit mindestens einer Leiterplatte (10) nach einem der Ansprüche 6 bis 10 und einem Linsenelement, das vor der Leiterplatte (10) angeordnet ist.
